# EUROPEAN PATENT SPECIFICATION

(11) **EP 4 333 593 B1**
(45) Date of publication and mention of the grant of the patent: **12.11.2025**
(21) Application number: 23723402.6
(22) Date of filing: 24.04.2023
(51) Int. Cl.: H10K 50/844, G06F 1/16, G09F 9/30, H10K 77/10, H10K 50/842, H04M 1/02, H10K 102/00, H05K 5/06, H04M 1/18

(54) **ELECTRONIC APPARATUS INCLUDING STRUCTURE FOR PROTECTING DISPLAY**
ELEKTRONISCHE VORRICHTUNG MIT STRUKTUR ZUM SCHUTZ EINER ANZEIGE
APPAREIL ÉLECTRONIQUE COMPRENANT UNE STRUCTURE DE PROTECTION D'AFFICHAGE

(30) Priority: 20.07.2022 KR 20220089753; 09.08.2022 KR 20220099551
(43) Date of publication of application: 06.03.2024
(73) Proprietor: Samsung Electronics Co., Ltd., Suwon-Si, Gyeonggi-do 16677 (KR)
(72) Inventor: JUNG, Kiyoung, Suwon-si, Gyeonggi-do 16677 (KR); AN, Jungchul, Suwon-si, Gyeonggi-do 16677 (KR); KIM, Sangkyu, Suwon-si, Gyeonggi-do 16677 (KR); WOO, Jeong, Suwon-si, Gyeonggi-do 16677 (KR)
(74) Representative: Gulde & Partner
(86) International application number: PCT/KR2023/005578
(87) International publication number: WO 2024/019270

(56) References cited:
- KR-A- 20140 085 031
- KR-A- 20180 069 763
- KR-A- 20200 101 224
- KR-A- 20200 101 224
- KR-A- 20210 001 050
- KR-A- 20220 060 773
- KR-A- 20220 060 773

## Description

### [Technical Field]

Various embodiments of the present invention relate to an electronic device including a protection structure of a display.

### [Background Art]

An electronic device may include a display for providing visual information. The electronic device may further include a display driving circuit for controlling a plurality of pixels of a display panel. In a miniaturized electronic device, the display driving circuit may be disposed on a substrate extending from an edge of the display panel. The extending substrate may be a flexible substrate. KR 2022 0060773 A discloses an electronic device including a waterproof structure. KR 2020 0101224 A discloses a foldable electronic device including a protection member.

### [Disclosure]

### [Technical Solution]

According to an embodiment, an electronic device is provided as defined in the appended claims.

According to an unclaimed aspect, an electronic device comprises a sidewall providing at least a part of the side surface of the electronic device and a support portion extending from the sidewall to the inside of the electronic device, a first housing including a first surface facing a first direction, a second housing including a second surface facing the first direction, and a hinge structure providing an unfolded state in which the first surface and the second surface face the same direction or a folded state in which the first surface and the second surface face each other, by rotatably connecting the first housing 210 and the second housing 220 with respect to a folding axis. The electronic device comprises a display disposed on the first surface and the second surface across the folding axis and including a first display area corresponding to the first surface, a second display area corresponding to the second surface, and a third display area between the first display area and the second display area. According to an embodiment, the display includes a display panel, a protective film extending along a first surface of the display panel from the edge of the display toward the inside of the electronic device, and a display driving circuit disposed between the protective film and the display panel. The electronic device comprises a sealing member extending along the sidewall and disposed between the protective film and the supporting member. According to an embodiment, the electronic device includes a first elastic member in contact with the supporting portion, disposed between the display driving circuit and the sealing member, and elastically supporting the protective film. According to an embodiment, the display panel includes a resin in contact with a second side surface facing the first side surface of the display driving circuit facing the first elastic member. The protective film includes a first portion contacting the sealing member, a second portion contacting the supporting member, and a third portion extending from the first portion to the second portion. The first elastic member is surrounded by the third portion and the supporting member.

### [Description of the Drawings]

FIG. 1 is a block diagram of an electronic device in a network environment according to various embodiments.
FIG. 2A illustrates an example of an unfolded state of an electronic device according to an embodiment.
FIG. 2B illustrates an example of a folded state of an electronic device according to an embodiment.
FIG. 2C is an exploded view of an exemplary electronic device according to an embodiment.
FIG. 3 is a rear view illustrating a rear surface of a side surface supporting member of an exemplary electronic device according to an embodiment.
FIG. 4 is a rear view illustrating a rear surface of an exemplary display panel according to an embodiment.
FIG. 5 exemplarily illustrates the arrangement of a sealing member and a sponge on a supporting member in area A of FIG. 3.
FIG. 6 is a cross-sectional view taken along line B-B' of the exemplary electronic device of FIG. 5.
FIG. 7 exemplarily illustrates the arrangement of sealing members and sponges on a supporting member in region A of FIG. 3.
FIGS. 8A, 8B, 8C, and 8D are cross-sectional views illustrating examples in which the electronic device of FIG. 7 is cut along C-C'.
FIG. 9 exemplarily illustrates the arrangement of sealing members on a supporting member and sponges surrounding the display driving circuit in the area A of FIG. 3.

### [Mode for Invention]

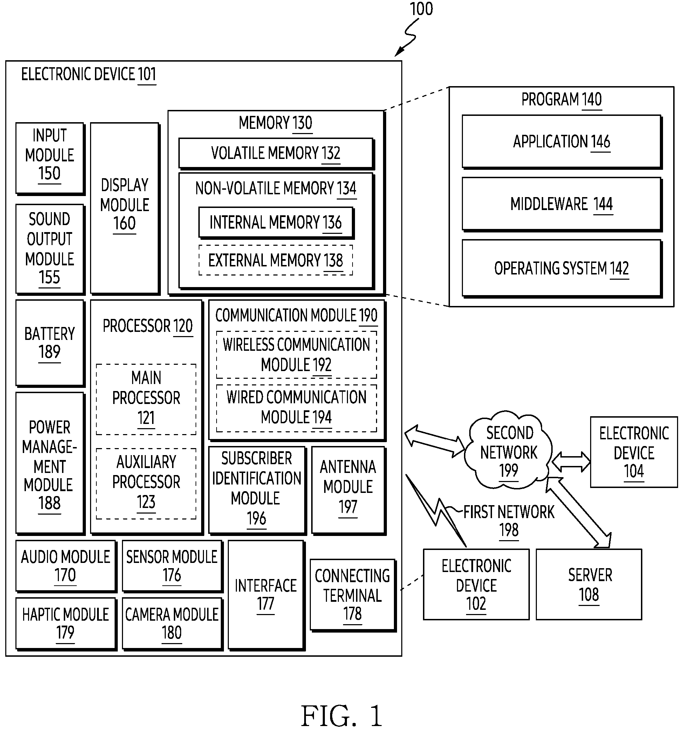

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

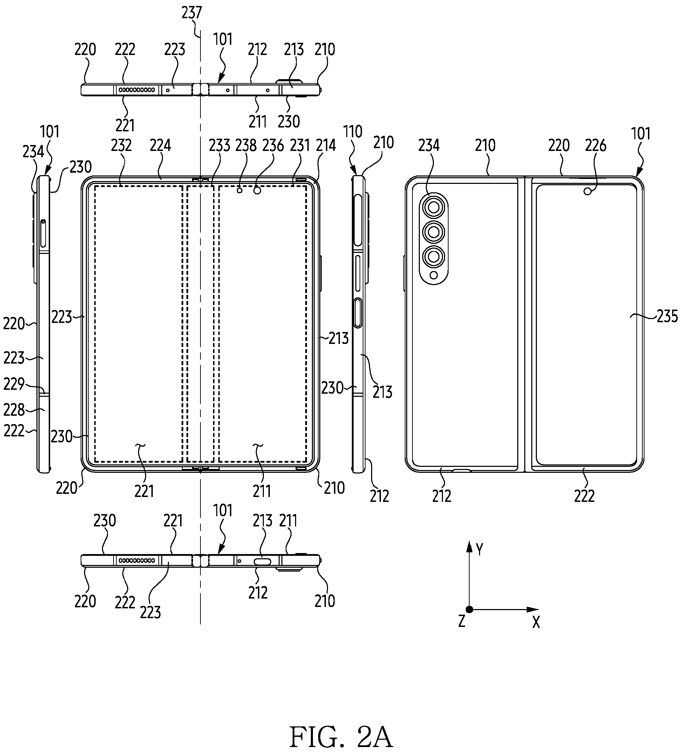

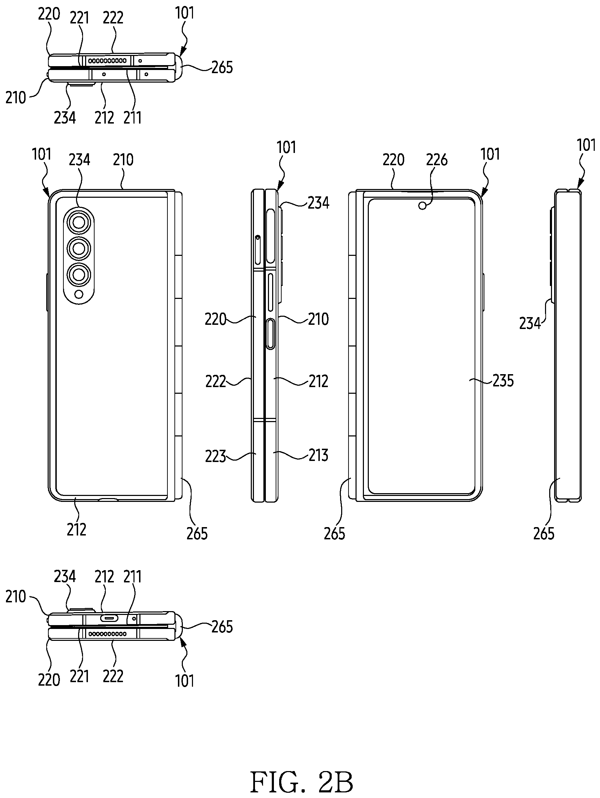

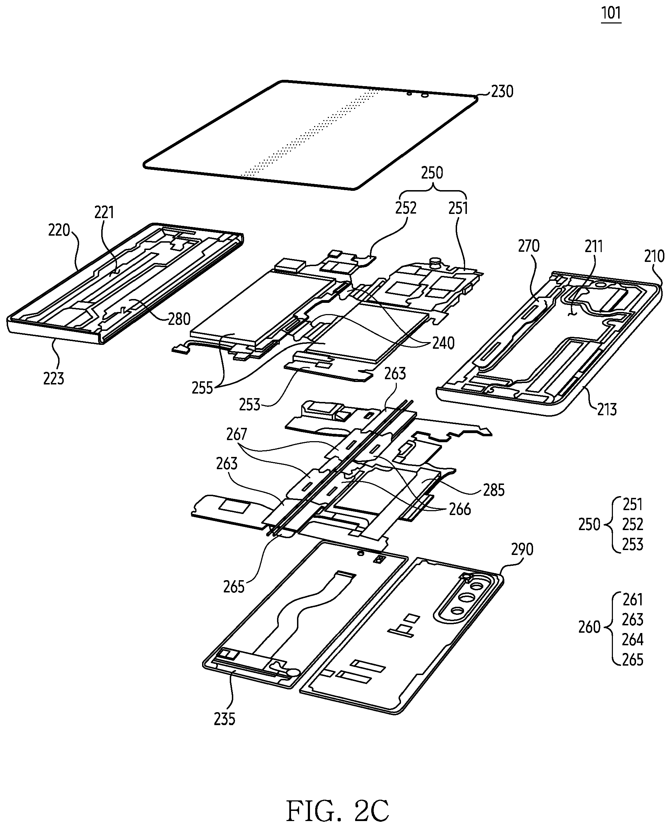

FIG. 2A illustrates an example of an unfolded state of an electronic device according to an embodiment, FIG. 2B illustrates an example of a folded state of the electronic device according to an embodiment, and FIG. 2C illustrates an exploded view of the electronic device according to an embodiment.

Referring to FIGS. 2A, 2B, and 2C, the electronic device 101 may include a first housing 210, a second housing 220, and a flexible display panel 230.

In one embodiment, the first housing 210 may include a first surface 211, a second surface 212 facing away the first surface 211, and a first side 213 surrounding at least a portion of the first surface 211 and the second surface 212. In an embodiment, the second surface 212 may further include at least one camera 234 exposed out through part of the second surface 212. In an embodiment, the first housing 210 may include a first protection member 214 disposed along an edge of the first surface 211. In an embodiment, the first housing 210 may provide a space formed by the first surface 211, the second surface 212, and the first side 213, for mounting therein various components of the electronic device 101. In an embodiment, the first side 213 and a second side 223 may include a conductive material, a non-conductive material, or a combination thereof. For example, the second side 223 may include a conductive member 228 and a non-conductive member 229. The conductive member 228 may include a plurality of conductive members, and the plurality of conductive members may be spaced apart from each other. The non-conductive member 229 may be disposed between the plurality of conductive members. An antenna structure may be formed by some of the plurality of conductive members and the plurality of non-conductive members or a combination thereof.

In an embodiment, the second housing 220 may include a third surface 221, a fourth surface 222 facing away the third surface 221, and a second side 223 surrounding at least part of the third surface 221. In an embodiment, the fourth surface 222 may further include a display panel 235 disposed thereon. A camera 226 may be disposed to face the fourth surface 222 from the inside of the second housing 220 so as to obtain an external image through the fourth surface 222. The camera 226 may be disposed underneath the display panel 235 to be covered by the display panel 235. In one embodiment, the camera 226 may be disposed underneath the display panel 235 and the display panel 235 may be aligned with a lens of the camera 226, so that it may include an aperture to transmit light from the outside to the camera 226. According to an embodiment, each of the first housing 210 and the second housing 220 may include a first protection member 214 and a second protection member 224, respectively. The first protective member 214 and the second protective member 224 may be disposed on the first surface 211 and the third surface 221 along a periphery of a flexible display panel 230. The first protective member 214 and the second protective member 224 may be formed to protect inflow of foreign substances (e.g., dust or moisture) through a gap between the flexible display panel 230 and the first housing 210 and the second housing 220. The first protection member 214 may be disposed along an edge of a first display area 231, and the second protection member 224 may be disposed along an edge of a second display area 232. The first protective member 214 may be formed attached to the first side 213 of the first housing 210, or may be formed integrally with the first side 213. The second protective member 224 may be formed attached to the second side 223 of the second housing 220, or may be formed integrally with the second side 223.

In an embodiment, the second side 223 may be pivotably or rotatably connected to the first side 213 through a hinge structure 260 mounted onto a hinge cover 265. The hinge structure 260 may include a hinge module 262, a first hinge plate 266, and a second hinge plate 267. The first hinge plate 266 may be connected to the first housing 210, and the second hinge plate 267 may be connected to the second housing 220. In an embodiment, the second housing 220 may provide a space defined by the third surface 221, the fourth surface 222 facing and spaced away from the third surface 221, and the side 223 surrounding at least part of the third surface 221 and the fourth surface 222, as a space for mounting various components of the electronic device 101. In an embodiment, the flexible display panel 230 may include a window exposed to the outside. The window may be formed to protect the surface of the flexible display panel 230 and include a transparent member, so as to transmit visual information provided from the flexible display panel 230 to the outside. The window may include a glass material such as e.g., ultra-thin glass (UTG) or a polymer material such as e.g., polyimide (PI). In an embodiment, the flexible display panel 230 may be disposed on the first surface 211 of the first housing 210 and the third surface 221 of the second housing 220 across the hinge cover 265. The flexible display panel 230 may include a first display area 231 disposed on the first surface 211 of the first housing, the second display area 232 disposed on the third surface 221 of the second housing, and a third display area 233 disposed between the first display area 231 and the second display area 232. The first display area 231, the second display area 232, and the third display area 233 may form a front surface of the flexible display panel 230.

According to an embodiment, an opening may be formed in a portion of the display area of the flexible display panel 230, or a recess or an opening may be formed in a supporting member (e.g., a bracket) supporting the flexible display panel 230. The electronic device 101 may include at least one of a sensor module 238 or a camera 236 aligned with the recess or the opening. For example, the first display area 231 may further include the camera 236 capable of acquiring an image from the outside through a part of the first display area 231 and the sensor module 238 generating an electrical signal or data value corresponding to an external environment state. According to an embodiment, one or more of the sensor module 238 or the camera 236 may be arranged on a back side of the flexible display panel 230 corresponding to the first display area 231 or the second display area 232 of the flexible display panel 230. For example, at least one of the camera 236 or the sensor module 238 may be disposed underneath the flexible display panel 230 to be covered by the flexible display panel 230. At least one of the camera 236 or the sensor module 238 may be covered by the flexible display panel 230 so as to be not exposed to the outside. However, the configuration is not limited thereto, and the flexible display panel 230 may include an opening for exposing the camera 236 and/or the sensor module 238 to the outside. Although not shown in FIGS. 2A and 2B, according to an embodiment, the flexible display panel 230 may further include a rear surface opposite to the front surface. In an embodiment, the flexible display panel 230 may be supported by a first supporting member 270 of the first housing 210 and a second supporting member 280 of the second housing 220.

In an embodiment, the hinge structure 260 may be configured to rotatably connect the first supporting member 270 forming the first housing 210 and fastened to the first hinge plate 266, and the second supporting member 280 forming the second housing 220 and fastened to the second hinge plate 267.

In an embodiment, the hinge cover 265 surrounding the hinge structure 260 may be at least partially exposed to the outside through between the first housing 210 and the second housing 220, while the electronic device 101 is in the folded state. In another embodiment, the hinge cover 265 may be covered by the first housing 210 and the second housing 220 while the electronic device 101 is in the unfolded state.

In an embodiment, the electronic device 101 may be configured to be folded with respect to a folding shaft 237 passing through the hinge cover 265. For example, the hinge cover 265 may be disposed in between the first housing 210 and the second housing 220 of the electronic device 101 to allow the electronic device 101 to be bent, curved or folded. For example, the first housing 210 may be connected to the second housing 220 through the hinge structure 260 mounted on the hinge cover 265, and may rotate with respect to the folding shaft 237. For example, the hinge structure 260 may include hinge modules 262 disposed at both ends of the first hinge plate 266 and the second hinge plate 267. The hinge module 262 may include hinge gears engaged with each other therein, so that the first hinge plate 266 and the second hinge plate 267 are caused to rotate about the folding axis. The first housing 210 coupled to the first hinge plate 266 may be connected to the second housing 220 coupled to the second hinge plate 267, and may be caused to rotate about the folding axis by the hinge modules 262.

In an embodiment, the electronic device 101 may be folded to face each other by rotating the first housing 210 and the second housing 220 with respect to the folding shaft 237. In an embodiment, the electronic device 101 may be folded such that the first housing 210 and the second housing 220 can be laid over or overlap each other.

Referring to FIG. 2C, the electronic device 101 may include a first supporting member 270, a second supporting member 280, a hinge structure 260, a flexible display panel 230, and a printed circuit board 250, a battery 255, a hinge cover 265, an antenna 285, a display panel 235 and a rear plate 290. According to an embodiment, the electronic device 101 may omit at least one of those components or may further include one or more other components. At least one of the components of the electronic device 300 may be the same as or similar to at least one of the components of the electronic device 101 of FIGS. 1, 2A, or 2B, and redundant descriptions thereof will be refrained from the following.

The first housing 210 and the second housing 220 may support a flexible display (e.g., the flexible display 230 of FIG. 2A). The flexible display panel may include a front surface that emits light and provides information, and a rear surface facing the front surface. In the case that the first surface of the first housing 210 (e.g., the first surface 211 of FIG. 2A) faces the third surface of the second housing 220 (e.g., the third surface 221 of FIG. 2A), the flexible display panel may be in a folding state in which the first display area 231 and the second display area 232 face each other. In case that the first surface 211 of the first housing 210 and the third surface 221 of the second housing 220 look in the same direction, the flexible display 230 may be in an unfolded state in which the first display area 231 and the second display area 232 of the flexible display 230 look in the same direction.

According to an embodiment, the electronic device 101 may provide a fully unfolded state by the hinge structure 260 of the first housing 210 and the second housing 220. The first support member (270) is connected to the second support member (280) through the hinge structure (260) so that the electronic device (101) can be converted into a folding state or an unfolding state. The first support member 270 and the second support member 280 attached to the hinge plates 266 and 267 of the hinge structure 260 may move, by rotating the hinge gear 263. The hinge plates 266 and 267 may include a first hinge plate 266 coupled to the first support member 270 and a second hinge plate 267 coupled to the second support member 280. The electronic device 101 may be switched to a folding state or an unfolding state by rotation of the hinge gear 263.

The hinge structure 260 may include a hinge module 262, a first hinge plate 266, and a second hinge plate 267. The hinge module 262 may include a hinge gear 263 that causes the first hinge plate 266 and the second hinge plate 267 to be pivotable. The hinge gears 263 may rotate with being engaged with each other to cause the first hinge plate 266 and the second hinge plate 267 to rotate. The hinge module 262 may include a plurality of hinge modules. Each of the plurality of hinge modules may be disposed at both ends formed by the first hinge plate 266 and the second hinge plate 267.

The first hinge plate 266 may be coupled to the first supporting member 270 of the first housing 210, and the second hinge plate 267 may be coupled to the second supporting member 280 of the second housing 220. The first housing 210 and the second housing 220 may rotate corresponding to the rotation of the first hinge plate 266 and the second hinge plate 267.

The first housing 210 may include the first supporting member 270 and the second supporting member 280. The first supporting member 270 may be partially surrounded by the first side 213, and the second supporting member 280 may be partially surrounded by the second side 223. The first supporting member 270 may be integrally formed with the first side 213, and the second supporting member 280 may be integrally formed with the second side 223. According to an embodiment, the first supporting member 270 may be formed separately from the first side 213, and the second supporting member 280 may be formed separately from the second side 223. The first side 213 and the second side 223 may be formed of a metal material, a non-metal material, or a combination thereof, and may be used as an antenna.

The first supporting member 270 may be coupled to the flexible display panel 230 on one surface, and coupled to the rear plate 290 on the other surface. Further, the second supporting member 280 may be coupled to the flexible display panel 230 on one surface and coupled to the display panel 235 on the other surface.

The printed circuit board 250 and the battery 255 may be disposed in between a surface formed by the first supporting member 270 and the second supporting member 280 and a surface formed by the display panel 235 and the rear plate 290. The printed circuit board 250 may be separated to be disposed on each of the first supporting member 270 of the first housing 210 and the second supporting member 280 of the second housing 220. The shapes of the first printed circuit board 251 disposed on the first supporting member 270 and the second printed circuit board 252 disposed on the second supporting member 280 may be different from each other depending on the space inside the electronic device. Components for implementing various functions of the electronic device 10 may be mounted onto the first printed circuit board 251 and the second printed circuit board 252. According to an embodiment, on the first printed circuit board 251 may be mounted various components for implementing the overall function of the electronic device 101, and on the second printed circuit board 252 may be disposed various electronic components for implementing some functions of the first printed circuit board 251 or components for driving the display panel 235 disposed on the fourth surface 222. The first printed circuit board 251 and the second printed circuit board 252 may be electrically connected to each other by a flexible printed circuit board 240.

The battery 255 may be, for example, a device to supply electric power to one or more of the components of the electronic device 101, and may include, for example, a non-rechargeable primary battery, or a rechargeable secondary battery, or a fuel cell. At least some of the battery 255 may be disposed on substantially the same plane as the printed circuit board 250. The surfaces of the printed circuit board 250 and the battery 255, which are formed with substantially the same surface, may be disposed on one surface of the first supporting member 270 and the second supporting member 280 (e.g., a side facing the second surface 212 and the fourth surface 222, or a side facing the display panel 235 and the rear plate 290). For example, the flexible display panel 230 may be disposed on the first surface 211 and the third surface 221, and the printed circuit board 250 and the battery 255 may be disposed on the second surface 212 and the fourth surface 222 facing the side on which the flexible display panel 230 is disposed.

In one embodiment, the antenna 285 may be disposed between the rear plate 290 and the battery 255 in one embodiment. The antenna 285 may include, for example, a near field communication (NFC) antenna, a wireless charging antenna, and/or a magnetic secure transmission (MST) antenna. The antenna 285 may, for example, perform short-range communication with an external device or wirelessly transmit/receive power required for charging.

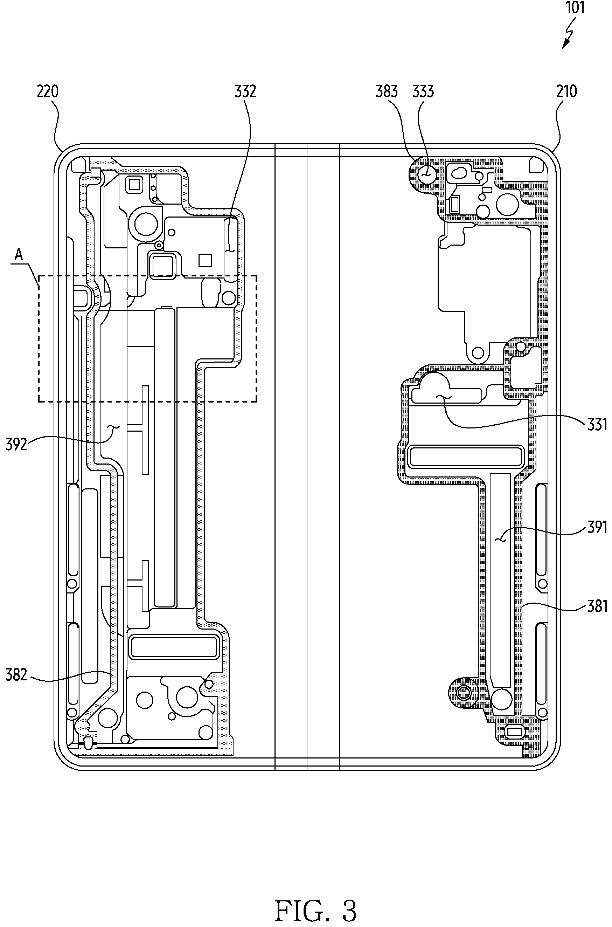

FIG. 3 is a rear view illustrating a rear surface of a side surface supporting member of an exemplary electronic device according to an embodiment.

A first sealing tape 381 may be applied to a first surface (e.g., the first surface 211 of FIG. 2A) of the first housing 210. A second sealing tape 382 may be applied to a second surface (e.g., the second surface 212 of FIG. 2A) of the second housing 220. The first sealing tape 381 and the second sealing tape 382 may prevent moisture introduced through a gap between the hinge structure 260 and the hinge cover 265, the first housing 210, and the second housing 220 from being transferred to an electronic component mounted inside the electronic device 101. Each of the first sealing tape 381 and the second sealing tape 382 may be disposed on the first surface 211 and the second surface 212 in closed curves.

The first sealing tape 381 may form a first sealing area 391 that blocks the inflow of moisture. For example, the first sealing tape 381 may prevent moisture introduced through a gap between the hinge cover 265 and the hinge structure 260, and a gap between the hinge structure 260 and the hinge cover 265 and reaching the first surface 211 from being transferred to components such as a printed circuit board and/or a processor disposed on the second surface 212, by surrounding the area where the opening 331 penetrating the first housing 210 and connecting the first surface 211 and the second surface (e.g., the second surface 212 of FIG. 2A) is located.

The second sealing tape 382 may form a second sealing area 392 where the inflow of moisture is blocked by the second sealing tape 382. For example, the second sealing tape 382 may prevent moisture located on the third surface 221 from being transferred to components such as a printed circuit board and/or a battery disposed on the fourth surface 222, through the second housing 220, by surrounding the area where the opening 332 connecting the third surface 221 and the fourth surface 222 is located.

According to an embodiment, the first housing 210 may further include a third sealing tape 383 applied on the first surface 211. The third sealing tape 383 may surround an opening 333 that transmits light to a camera (not shown) disposed under the flexible display (e.g., the flexible display 230 of FIG. 2C). The opening 333 for transmitting light to the camera may penetrate the first surface 211 in contact with the flexible display 230 and the second surface 212 facing the first surface 211. The moisture introduced from the outside and positioned on the first surface 211 may flow into the components positioned on the second surface 212 through a gap between the opening 333 and the camera. The third sealing tape 383 may prevent external moisture introduced through the gap between the hinge structure 260 and the first housing 210 and the second housing 220 from entering into the electronic device along the gap between the camera and the opening 333. The sealing tape may further include sealing members such as a sealing tape, a rubber, and a sealing resin (e.g., cured in placed gasket (CIPG)) as well as the first sealing tape 381, the second sealing tape 382, and the third sealing tape 383 in order to block the flow of moisture through the openings formed in the support surfaces of the first housing 210 and the second housing 220. For example, the second housing 220 may further include a sealing tape forming a closed curve along the edge of the fourth surface 222 on the fourth surface 222 facing the display panel 235.

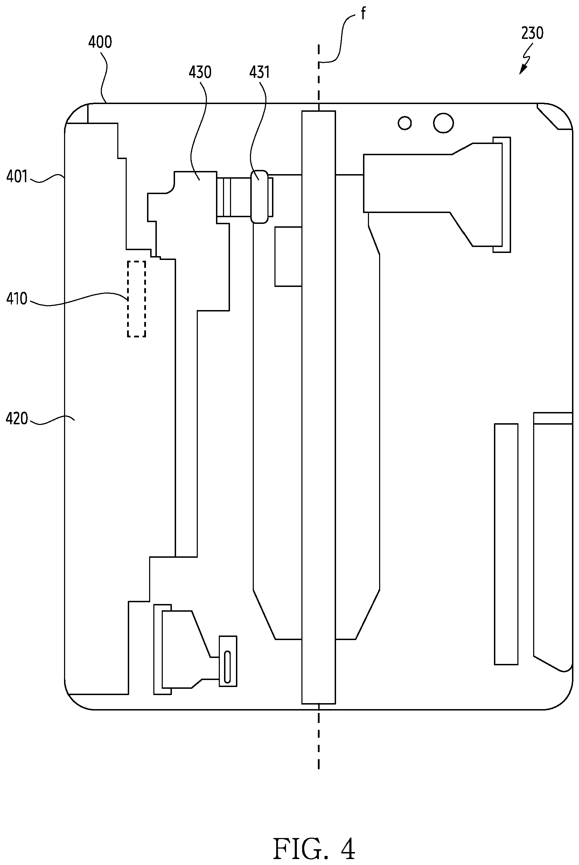

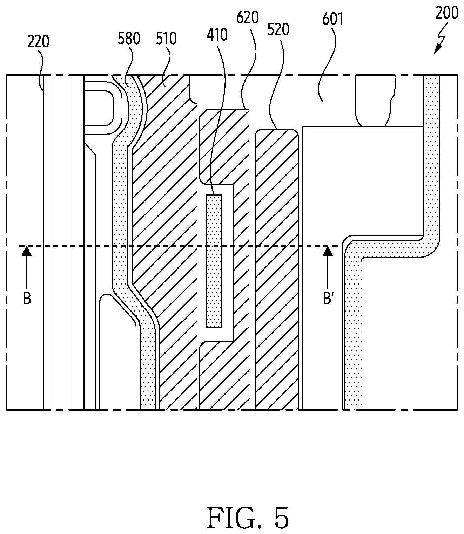

FIG. 4 is a rear view illustrating a rear surface of an exemplary display panel according to an embodiment. FIG. 5 exemplarily illustrates the arrangement of a sealing member and a sponge on a supporting member in area A of FIG. 3.

Referring to FIGS. 4 and 5, the display 230 may include a display panel 400, a display driving circuit 410, a protective film 420, and/or a flexible printed circuit board 430.

The display panel 400 may transmit light to the outside of the electronic device 200 (e.g., the electronic device 101 of FIG. 2A) in order to provide visual information to the outside. The display panel 400 may include a structure for emitting light. For example, the display panel 400 may include an electrode, a thin film transistor (TFT), and a pixel. The display panel 400 may be an organic light emitting diode (OLED) panel including pixels including an organic light emitting material. However, it is not limited thereto, and the display panel 400 may include a liquid crystal display (LCD) panel, a light emitting diode (LED) panel, a micro LED panel, or a quantum dot LED (QLED). The display panel 400 may be referred to as a flexible display panel in terms of being foldable or deformable based on a folding axis f. The display 230 may be referred to as a flexible display in terms of including a flexible display panel. The display panel 400 may include a foldable display panel or a rollable display panel. The display panel 400 may include a substrate (e.g., polyimide (PI)) having flexibility to provide flexibility. Although the display 230 described later is described based on a flexible display, but the electronic device including a structure for protecting the display driving circuit according to an embodiment may be equally or similarly applied as a structure for protecting the display driving circuit of a display that is not deformed.

The display 230 may include a display driving circuit 410 (e.g., DDI, display drive integrated circuit) disposed under the display panel. The display driving circuit 410 may include an interface module, a memory (e.g., a buffer memory), an image processing module, or a mapping module. The display driving circuit 410 may receive image data or image information including an image control signal corresponding to the command for controlling the image data from other components of the electronic device 200 (e.g., the processor 120, the main processor 121, or the auxiliary processor 123) through the interface module. The display driving circuit 410 may pre-process or post-process the received image information, and may generate a voltage value or a current value corresponding to the pre-processed or post-processed image information. The display driving circuit 410 may drive pixels of the display panel 400 based on the voltage value or the current value.

According to an embodiment, the display driving circuit 410 may be disposed on the rear surface of the display panel 400. The pixels may transmit light to the outside through the front surface of the display panel 400. The rear surface of the display panel 400 may be a surface seated on the second housing 220 of the electronic device 200. The display driving circuit 410 may be disposed to be spaced apart from one edge 401 of the display panel 400. The display driving circuit 410 may be disposed on an extended substrate of the display panel 400. The substrate may include a flexible material (e.g., polyimide). However, the present invention is not limited thereto, and the display driving circuit 410 may be disposed on a glass substrate or a film. The display driving circuit 410 may be electrically connected to the display panel 400 by being disposed on a substrate extending from the display panel 400.

The display 230 may include a protective film 420 surrounding the display driving circuit 410. The protective film 420 may extend from one edge 401 of the display panel 400 toward the folding axis f. The protective film 420 may cover the display driving circuit 410. The display driving circuit 410 may be protected by being surrounded by a protective film 420.

According to an embodiment, the display 230 may further include a flexible printed circuit board 430. The flexible printed circuit board 430 may be connected to the display driving circuit 410. The flexible printed circuit board 430 may include a connector 431. The flexible printed circuit board 430 may be connected to a printed circuit board (e.g., the printed circuit board 250 of FIG. 2C) through the connector 431. The display 230 may be electrically connected to a processor (e.g., the processor 120 of FIG. 1) on the printed circuit board 250 through the flexible printed circuit board 430.

Referring to FIG. 5, the electronic device 200 may include a supporting member 601 in a housing supporting the display 230.

According to an embodiment, the supporting member 601 may extend from the side surface of the second housing 220 to the inside of the second housing 220 (e.g., the inside of the electronic device 200). One surface of the supporting member 601 may support the display 230. Another surface of the supporting member 601 opposite to the one surface may support the printed circuit board 250.

According to an embodiment, the electronic device 200 may include a sealing member 580 disposed on the supporting member 601. The sealing member 580 may block at least a part of the path of foreign material introduced through a part of the side surface of the housing within the housing (e.g., the second housing 220) and may be disposed on the supporting member 601.

According to an embodiment, the display driving circuit 410 may be disposed in a sealing area (e.g., the first sealing area 391 or the second sealing area 392 of FIG. 3) formed by the sealing member 580. For example, the display driving circuit 410 may be disposed in the second sealing area 392 in the second housing 220. The second sealing area 392 may prevent foreign materials introduced through a structure (e.g., a hinge structure or a key button) disposed on a part of the side surface of the second housing 220 from being transferred to the display driving circuit 410. For example, the sealing member 580 may be the second sealing tape 382 of FIG. 3 disposed in the second housing 220. The foreign material may be moisture or a fine material. The sealing member 580 may be referred to as a waterproof member in terms of reducing moisture introduced from the outside. The sealing member 580 may be referred to as a dustproof member in terms of reducing fine materials introduced from the outside.

According to an embodiment, the electronic device 200 may include a first elastic member 510 disposed on the supporting member 601. The first elastic member 510 may be disposed between the sealing member 580 and the display driving circuit 410. The first elastic member 510 may be spaced apart from the sealing member 580 and may be spaced apart from the display driving circuit 410.

According to an embodiment, the electronic device 200 may include a second elastic member 520 disposed on the supporting member 601. The second elastic member 520 may face the first elastic member 510 with the display driving circuit 410 interposed therebetween. For example, the display driving circuit 410 may be disposed between the first elastic member 510 and the second elastic member 520. The second elastic member 520 may be spaced apart from the display driving circuit 410 and may be in contact with the supporting member 601. The protective film 420 may extend from the first elastic member 510 to surround the display driving circuit 410, and may extend between the second elastic member 520 and the display panel 610.

According to an embodiment, the electronic device 200 may further include a resin 620 disposed on the supporting member 601. The resin 620 may surround a part of the display driving circuit 410. The resin 620 may be disposed between the first elastic member 510 and the second elastic member 520. The resin 620 may surround the display driving circuit 410 together with the first elastic member 510. The resin 620 may be in contact with the second side surface opposite to the first side surface of the display driving circuit 410 facing the first elastic member 510. The resin 620 may alleviate an impact applied from the side surface of the display driving circuit 410 by contacting the side surface of the display driving circuit 410. Although a material disposed on the supporting member 601 is described as the resin 620, the present invention is not limited thereto. Instead of the resin 620, a non-conductive member may be disposed on the supporting member 601.

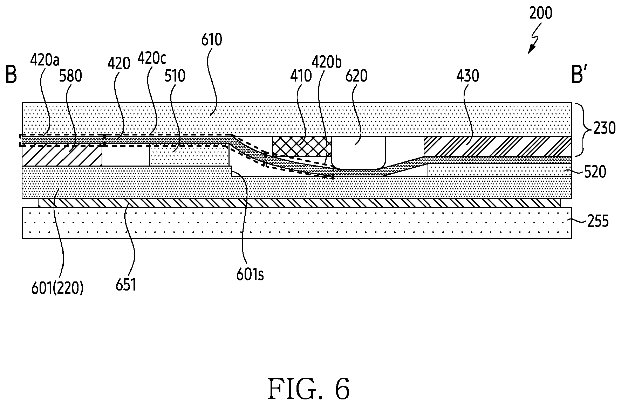

Based on the above-described planar arrangement of the first elastic member, the sealing member, and the display driving circuit, a vertical arrangement will be described with reference to FIG. 6.

FIG. 6 is a cross-sectional view taken along line B-B' of the exemplary electronic device of FIG. 5.

Referring to FIG. 6, the electronic device 200 may include the display 230, the supporting member 601, and the battery 255.

Although the structure of the electronic device 200 is described based on a case where the display driving circuit 410 is disposed in the second housing 220, but the structure of FIG. 6 may be the structure of the first housing 210 in case that the display driving circuit 410 is disposed in the first housing 210. Even when the electronic device 200 is not a foldable electronic device, the structure of FIG. 6 may be applied in the housing.

According to an embodiment, the supporting member 601 may be a part of the second housing 220. The supporting member 601 may extend from the side surface of the second housing 220 (e.g., the second side surface 223 of FIG. 2A) to the inside of the electronic device 200 or the second housing 220. The supporting member 601 may support the display 230.

According to an embodiment, the display 230 in the first housing 210 and the second housing 220 may include the display panel 610. The display panel 610 may face the outside of the electronic device 200. A protective film or a protective panel may be disposed on the display panel 610. The protective film or protective panel may include a polymer or glass made of a transparent material. When the electronic device 200 is a foldable electronic device, the glass may be an ultra-thin glass (UTG) having flexibility and elasticity.

The electronic device 200 may include the display driving circuit 410 disposed under the display panel 610 and the protective film 420 surrounding the display driving circuit 410. The protective film 420 may at least partially surround a rear surface (e.g., a surface facing downward in FIG. 6) of the display panel 610. The display driving circuit 410 may be spaced apart from the second portion 420b of the protective film 420 in a direction toward which the display panel 610 faces. The protective film 420 may protect an integrated circuit (e.g., the display driving circuit 410 or a touch circuit (not shown)) and/or the flexible printed circuit board 430 disposed under the display panel 610. For example, the protective film 420 may protect the integrated circuit from foreign material introduced from the outside, or from state changes or external impacts caused by folding or unfolding of the electronic device 200, by surrounding the integrated circuit disposed under the display panel 610. The protective film 420 may surround at least a part of the flexible printed circuit board 430 connected to the display driving circuit 410 or the touch circuit. For example, the protective film 420 may protect a connection part of the flexible printed circuit board 430 by surrounding the end or boundary of the flexible printed circuit board 430 connected to the display driving circuit 410 or the touch circuit. The flexible printed circuit board 430 may electrically connect a printed circuit board (e.g., the printed circuit board 250 of FIG. 2C) to the display driving circuit 410 or the touch circuit. The flexible printed circuit board 430 and the protective film 420 may be supported by the second elastic member 520.

The electronic device 200 may include supporting member 601 of the second housing 220 supporting the display 230. The sealing member 580, the first elastic member 510, and the second elastic member 520 may be disposed on the supporting member 601. The supporting member 601 may support the first elastic member 510, the second elastic member 520, the sealing member 580 and the display 230. The supporting member 601 may be in contact with the protective film 420 of the display 230. The supporting member 601 may be in contact with the sealing member 580, the first elastic member 510, and the second elastic member 520. For example, the sealing member 580 such as a waterproof tape may be adhered to the supporting member 601. The first elastic member 510 and the second elastic member 520 may be interposed between the supporting member 601 and the display 230. The sealing member 580 and the first elastic member 510 on the supporting member 601 may contact the protective film 420.

According to an embodiment, the sealing member 580 may block at least a part of the path of the foreign material introduced through a part of the second side surface 223 of the second housing 220. The foreign material may be moisture. The sealing member 580 may provide a sealing area of the closed curve on the supporting member 601. The sealing member 580 may include a tape of a closed curve disposed between the sidewall of the second housing 220 and the first elastic member 510 and extending on the supporting member 601. The display driving circuit 410 or the touch circuit may be positioned in the sealing area. For example, the display driving circuit 410 or the touch circuit may be disposed within the closed curve of the sealing member 580. The sealing member 580 may prevent the transfer of the foreign material (e.g., moisture) introduced to the display driving circuit 410 and the touch circuit.

According to an embodiment, the first elastic member 510 may be disposed between the display 230 and the supporting member 601 to elastically support the display 230. The display panel 610 of the display 230 may be deformed due to external factors such as external impact or sagging due to a state change of the electronic device 200. The first elastic member 510 may be configured such that the display driving circuit 410 disposed on the rear surface of the display panel 610 or the rear surface of the display panel 610 does not contact the supporting member 601, from the deformation caused by the external factor. The first elastic member 510 may be disposed between the display driving circuit 410 and the sealing member 580. The first elastic member 510 may be disposed more adjacent to the display driving circuit 410 than the sealing member 580. For example, the distance between the display driving circuit 410 and the first elastic member 510 may be shorter than the distance between the first elastic member 510 and the sealing member 580. The first elastic member 510 may be a sponge made of a porous material. The first elastic member 510 may be compressed by an instantaneous impact, and may be restored to its original state by a restoring force when an external force such as an impact is removed. In the process of compression, the first elastic member 510 may prevent the external impact from being directly transmitted to the display 230, and the display panel 610 and/or the display driving circuit 410 included in the display 230 may not directly contact the supporting member 601.

The protective film 420 may include a first portion 420a of the protective film 420 in contact with the sealing member 580, a second portion 420b of the protective film different from the first portion, and a third portion 420c between the first portion 420a and the second portion 420b. The first portion 420a may be in contact with the sealing member 580. The sealing member 580 may reduce moisture introduced from the outside by filling a gap between the first portion 420a and the supporting member 601. The second portion 420b may be in contact with the supporting member 601. The second support portion 420b may be compressed by the resin 620 attached to the rear surface of the display panel 610. The resin 620 may be disposed on protective film 420. The resin 620 may be supported on the supporting member 601 by pressing the protective film 420. The resin 620 may be disposed adjacent to the side surface of the display driving circuit 410. The resin 620 may be thicker than the display driving circuit 410. The resin 620 thicker than the display driving circuit 410 may contact the protective film 420, and at least a part of the display driving circuit 410 may be spaced apart from the protective film 420. The resin 620 may separate the display driving circuit 410 from the protective film 420. Based on the separation, an air gap may be formed between the display driving circuit 410 and the protective film 420. Based on the air gap, the external impact transmitted from the supporting member 601 to the display driving circuit 410 may be reduced.

According to an embodiment, the first elastic member 510 embedded between the supporting member 601 and the protective film 420 may be disposed in a space formed by the sealing member 580, the third portion 420c of the protective film 420 extending from the first portion 420a to the second portion 420b, and the supporting member 601.

In the first area where the first portion 420a and the third portion 420c of the protective film 420 are disposed, the supporting member 601 may be spaced apart from the protective film 420 of the display 230 by a distance corresponding to the thicknesses of the sealing member 580 and the elastic member 510. In the second area where the second portion 420b of the protective film 420 contacts, the supporting member 601 may be spaced apart from the display panel 610 by a distance corresponding to the thicknesses of the protective film 420 and the resin 620. The supporting member 601 may include a step portion 601s between the first area and the second area.

According to an embodiment, the electronic device 200 may further include the battery 255 on a lower surface of the supporting member 601. The battery 255 may be attached to the supporting member 601. For example, the battery 255 may be attached to the supporting member 601 by an adhesive member 651 interposed between the battery 255 and the supporting member 601.

According to the above-described embodiment, the electronic device 200 may include a structure for reducing damage to the display driving circuit 410 due to sagging of the display 230 or the display panel 610. The structure may include the first elastic member 510, the second elastic member 520, and the resin 620. The resin 620 may reduce an impact applied to the side surface of the display driving circuit 410. The resin 620 may separate the display driving circuit 410 from the supporting member 601. Based on the separation, the resin 620 may reduce damage to one surface of the display driving circuit 410 facing the supporting member 601. The first elastic member 510 may be disposed between the sealing member 580 and the display driving circuit 410, and may be disposed closer to the display driving circuit 410. The first elastic member 510 may prevent the display 230 and the display panel 610 from being sagging. For example, the first elastic member 510 disposed adjacent to the display driving circuit 410 may prevent the driving circuit attachment area of the display panel 610 to which the display driving circuit 410 is attached from sagging. Since the sagging of the display panel 610 is prevented, the direct contact of the display driving circuit 410 with the supporting member 601 may be reduced. A damage to the display driving circuit 410 maintaining a distance from the supporting member 601 may be reduced through the first elastic member 510. The second elastic member 520 may support the display panel 610 and a part of the display 230. The second elastic member 520 may support a part of the protective film 420 in contact with the flexible printed circuit board 631. The first elastic member 510, the second elastic member 520, and the resin 620 may protect the display driving circuit 410 by supporting the display 230 or the display panel 610.

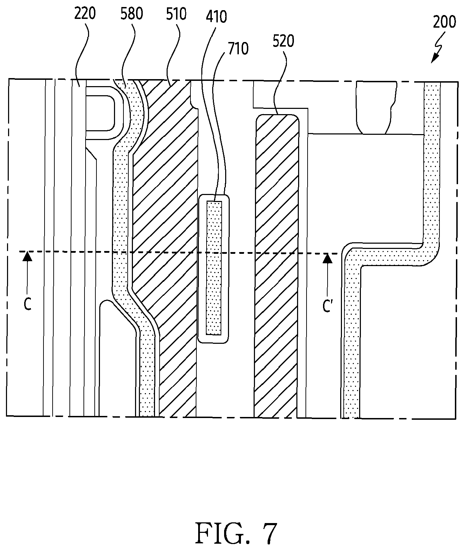

FIG. 7 exemplarily illustrates the arrangement of sealing members and sponges on a supporting member in region A of FIG. 3.

Referring to FIG. 7, the electronic device 200 may include the sealing member 580, the first elastic member 510, the display driving circuit 410, and the second elastic member 520 in the second housing 220. A structure and arrangement of the sealing member 580, the first elastic member 510, and/or the second elastic member 520 may be the same as or similar to a structure of the sealing member 580, the first elastic member 510, and/or the second elastic member 520 of FIG. 5. Among the descriptions of the sealing member 580, the first elastic member 510, and/or the second elastic member 520, parts overlapping the description of FIG. 5 will be omitted.

According to an embodiment, the second housing 220 may include an opening 710 in an area corresponding to the display driving circuit 410. The display driving circuit 410 may be spaced apart from the opening 710 in a direction toward the display (e.g., the display 230 of FIG. 2A). The display driving circuit 410 may be supported by a protective film (e.g., the protective film 420 of FIG. 4).

According to an embodiment, the opening 710 may be formed wider than the display driving circuit 410. For example, when the second housing 220 is viewed from above, the opening 710 may overlap the display driving circuit 410. The display driving circuit 410 may overlap a portion of the opening 710. When the second housing 220 is viewed from above, the edge of the opening 710 may surround along the edge of the display driving circuit 410. The opening 710 may provide an air gap between the display driving circuit 410 and the battery (e.g., the battery 255 of FIG. 2C) by removing the structure of the second housing 220 (e.g., the supporting member 601 of FIG. 6) disposed under the display driving circuit 410. The rear surface of the display driving circuit 410 may be protected based on the air gap.

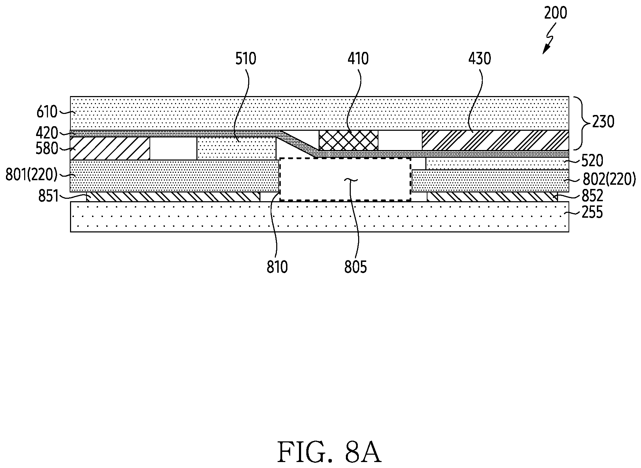

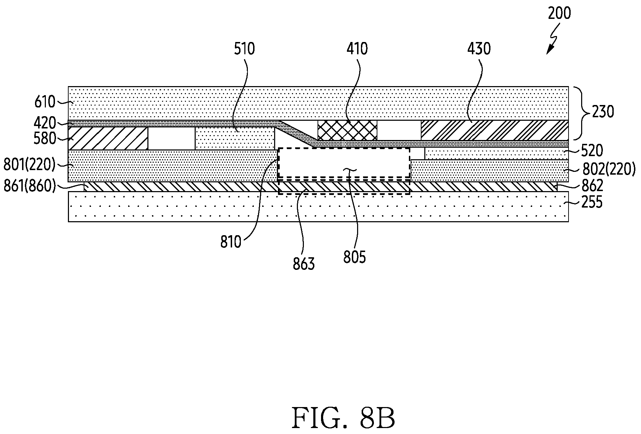

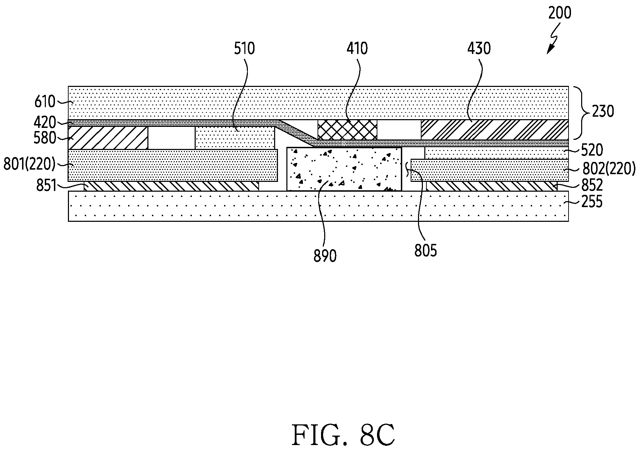

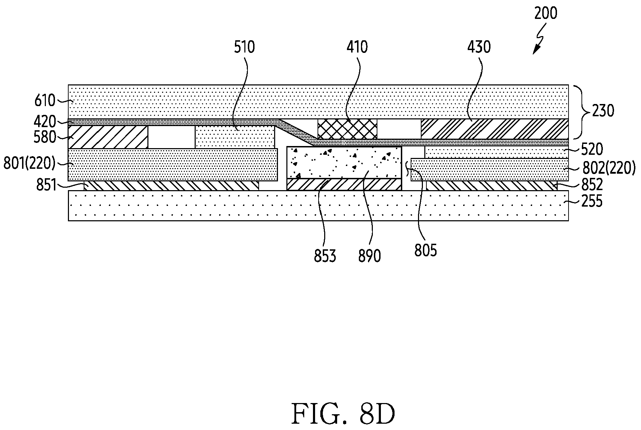

Based on the above-described planar arrangement of the first elastic member, the sealing member, and the display driving circuit, a vertical arrangement will be described with reference to FIGS. 8A, 8B, 8C, and 8D.

FIGS. 8A, 8B, 8C, and 8D are cross-sectional views illustrating examples in which the electronic device of FIG. 7 is cut along C-C'.

Referring to FIGS. 8A, 8B, 8C, and 8D, the structures of the first elastic member 510, the second elastic member 520, and the sealing member 580 may be the same as or similar to structures of the display 230, the first elastic member 510, the second elastic member 520, and the sealing member 580 of FIG. 6. The description overlapping the description of FIG. 6 will be omitted.

According to an embodiment, the display 230 may include the display panel 610, the display driving circuit 410, the protective film 420, and the flexible printed circuit board 430. The display 230 may remove a resin (e.g., the resin 620 of FIG. 6). The protective film 420 from which the resin 620 is removed may be in contact with one surface of the display driving circuit 410. According to an embodiment, the first portion 420a may be in contact with the sealing member 580, and the second portion 420b may be in contact with one surface of the display driving circuit 410. The third portion 420c may extend from the first portion 420a to the second portion 420b. The first elastic member 510 may be interposed between a portion 801 adjacent to the side surface of the supporting member 801, 802 and the protective film 420. The first elastic member 510 may be disposed in a space provided by the sealing member 580, the second portion 420b of the protective film 420, and the portion 801 of the supporting member.

According to an embodiment, the display driving circuit 410 may be in direct contact with the protective film 420 by removing a resin (e.g., the resin 620 of FIG. 6). The protective film 420 may support the display driving circuit 410. The display driving circuit 410 may be disposed between the display panel 610 and the protective film 420. Although the air gap between the protective film 420 and the display driving circuit 410 is removed, since the supporting members 801, 802 under the display driving circuit 410 are removed, the display driving circuit 410 may be protected from external impact or sagging of the display 230.

Referring to FIG. 8A, the electronic device 200 may include an opening 805 (e.g., the opening 710 of FIG. 7) formed in the supporting member 801 and 802. The opening 805 formed in the supporting members 801 and 802 may separate the display driving circuit 410 from the supporting members 801 and 802 or the battery 255. The opening 805 may expand the air gap 810 between the display driving circuit 410 and the other part 802, which is a supporting member under the display driving circuit 410, into a space between the display driving circuit 410 and the battery 255. The electronic device 200 may provide a rear protective structure of the display driving circuit 410 based on the expanded air gap 810. The air gap 810 may be surrounded by the battery 255, the supporting members 801, 802, and the protective film 420.

According to an embodiment, the supporting member 801 and 802 may include the opening 805. The supporting members 801 and 802 may be divided into a portion 801 and another portion 802 based on the opening 805 or the display driving circuit 410. The sealing member 580 and the first elastic member 510 may be disposed in the portion 801, which is close to the side surface of the second housing 220, based on the display driving circuit 410. Based on the display driving circuit 410, the second elastic member 520 may be disposed in the other portion 802 far from the side surface of the second housing 220. When the display 230 is viewed from above, the opening 805 may overlap the display driving circuit 410.

Since the air gap 810 is sufficiently provided on the rear surface of the display driving circuit 410 of the opening 805, the resin 620 of FIG. 6 may be removed. For example, in FIG. 6, a gap between the rear surface of the display driving circuit 410 and the supporting member 601 may be provided through the resin 620 of FIG. 6. Since the air gap 810 between the display driving circuit 410 and the battery 255 by the openings 805 of FIGS. 8A to 8D may be greater than the air gap of FIG. 6, the electronic device 200 may not include a separate resin.

The battery 255 may be in contact with the supporting members 801 and 802. The battery 255 may be attached to the supporting members 801 and 802 through adhesive members 851 and 852. The adhesive members 851 and 852 may remove an area corresponding to the opening 805. The removed areas of the adhesive members 851 and 852 may provide an air gap 810 together with the opening 805. A portion 851 of the adhesive members 851 and 852 may couple the portion 801 of the supporting members 801 and 802 on which the first elastic member 510 and the sealing member 580 are disposed with the battery 255. The other part 852 of the adhesive members 851 and 852 may couple the remaining portion 802 of the supporting members 801 and 802 on which the second elastic member 520 is disposed with the battery 255.

In FIG. 8A, the display driving circuit 410 may be protected from external impact or sagging of the display panel 610 based on the first elastic member 510, the second elastic member 520, and the opening 805.

Referring to FIG. 8B, the adhesive member 860 may be integrally formed. A portion 861 of the adhesive member 860 may couple the portion 801 of the supporting members 801 and 802 on which the first elastic member 510 and the sealing member 580 are disposed with the battery 255. The remaining portion 862 of the adhesive member 860 may couple the remaining portion 802 of the supporting members 801 and 802 on which the second elastic member 520 is disposed with the battery 255. Unlike FIG. 8A, the adhesive member 860 may further include an adhesive member 863 in an area corresponding to the opening 805. The adhesive member 863 disposed in an area corresponding to the opening 805 may include a non-adhesive material. For example, the adhesive member 860 may include an adhesive material between the supporting members 801, 802 and the battery 255, and may include a non-adhesive material in an area in contact with the opening 805. The adhesive member 863 disposed in the area corresponding to the opening of the adhesive member 860 may prevent the battery 255 from being exposed, thereby reducing damage to the battery 255 due to contact with the edge of the opening 805 of the supporting member 801, 802. The air gap 810 may be secured through the opening 805. In order to prevent foreign materials that may be introduced through the opening 805 or by-products inside the electronic device 200 from being attached to the adhesive member 860, the adhesive member 863 corresponding to the opening 805 may be formed of a non-adhesive material.

Referring to FIG. 8C, the electronic device 200 may further include a buffer 890. The buffer 890 may include a sponge made of a porous material supporting the display driving circuit 410. The buffer 890 may elastically support the display driving circuit 410. The buffer 890 may be in contact with the protective film 420 at a position corresponding to the display driving circuit 410. For example, the protective film 420 may be disposed between the buffer 890 and the display driving circuit 410. For example, the buffer 890 may fill the air gap 810 of FIG. 8A. The buffer 890 may be wrapped by the battery 255, the supporting members 801 and 802, and the protective film 420. Even when the air gap 810 removes a material that impacts the rear surface of the display driving circuit 410, a damage to the display driving circuit 410 may occur due to momentary sagging of the display panel 610. The buffer 890 may alleviate an external impact to reduce damage to the display panel 400.

Referring to FIG. 8D, the electronic device 200 may attach the buffer 890 to the battery 255. The adhesive members 851, 852, and 853 may include adhesive members 851 and 852 coupling the supporting member and the battery 255 and adhesive members 853 coupling the buffer 890 and the battery 255. The adhesive member 853 interposed between the buffer 890 and the battery 255 may be disposed in an area corresponding to the opening 805. The adhesive member 853 may have a narrower cross-sectional area than the buffer 890. For example, the adhesive member 853 may fully overlap the buffer 890 when the display panel 610 is viewed from above. The electronic device may include another adhesive member including a non-adhesive material disposed between the adhesive member 853 and the remaining adhesive members 851 and 852.

The electronic devices of FIGS. 8C and 8D may protect the display driving circuit 410 and reduce damage caused by impact of the battery 255, by arranging the buffer 890.

The electronic device 200 according to the above-described embodiment may reduce the material cost of the display 230 by removing the resin 620. In the manufacturing process of the electronic device 200, the thickness of the electronic device 200 may be reduced by removing the resin 620 relatively thicker than the display driving circuit 410. As the thick resin 620 is removed from the electronic device 200, the battery capacity may be increased.

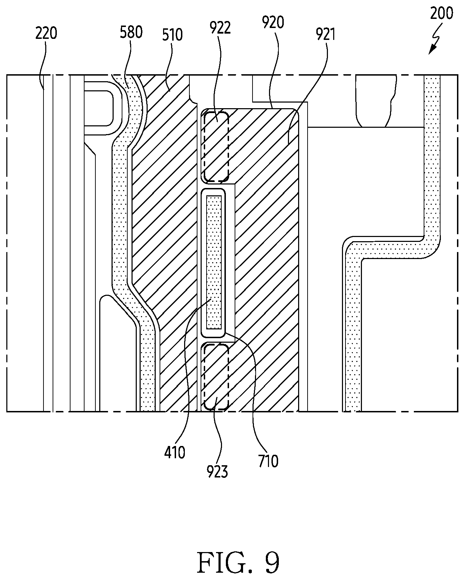

FIG. 9 exemplarily illustrates the arrangement of sealing members on a supporting member and sponges surrounding the display driving circuit in the area A of FIG. 3.

Referring to FIG. 9, the electronic device 200 may include the sealing member 580, the first elastic member 510, the display driving circuit 410, and the second elastic member 920 in the second housing 220. A structure and arrangement of the sealing member 580, the first elastic member 510 and/or the second elastic member 920 may be similar to the structure of the sealing member 580, the first elastic member 510 and/or the second elastic member 520 of FIGS. 5 and 7. Among the descriptions of the sealing member 580, the first elastic member 510 and/or the second elastic member 520, parts overlapping with description of FIGS. 5 and 7 will be omitted.

According to an embodiment, the second housing 220 may include an opening 710 in an area corresponding to the display driving circuit 410. The display driving circuit 410 may be spaced apart from the opening 710 in a direction toward the display (e.g., the display 230 of FIG. 2A). The display driving circuit 410 may be supported by a protective film (e.g., the protective film 420 of FIG. 4).

According to an embodiment, the first elastic member 510 and the second elastic member 920 may surround the display driving circuit 410. The second elastic member 920 may extend along the side surface of the display driving circuit 410 facing the folding axis, in the first area 921. The second elastic member 920 may include a second region 922 and a third region 923 extending toward the first elastic member 510 on both sides of the first region 921. The second elastic member 920 may surround a part of the side surface of the display driving circuit 410. The first elastic member 910 may surround the remaining part of the side surface of the display driving circuit 410.

According to an embodiment, the second elastic member 920 may extend to an area in which the resin 620 of FIG. 6 is disposed. The second elastic member 920 may protect the side surface of the display driving circuit 410.

The electronic device (e.g., the electronic device 200 of FIG. 6) according to the above-described embodiment may include a housing (e.g., the second housing 220 of FIG. 6). The electronic device may include a display (e.g., the display 230 of FIG. 6) disposed in the housing. The display may include a display panel, a display driving circuit (e.g., the display driving circuit 410 in FIG. 6) in contact with the display panel, and a protective film (e.g., the protective film 420 in FIG. 6) covering the display driving circuit. The electronic device may further include the supporting member 601. The supporting member may extend from the side surface of the housing and may contact the display. The electronic device may include a sealing member (e.g., the sealing member 580 of FIG. 6). The sealing member may block at least a part of a path of the foreign material introduced through a part of the side surface of the housing and may be supported by the supporting member. The electronic device may include the first elastic member 510. The first elastic member may be disposed on the supporting member in the housing. The sealing member and the first elastic member on the supporting member may be attached to the protective film. A second part of the protective film different from the first part of the protective film contacting the sealing member may be attached to a part of the display driving circuit. The first elastic member may be disposed between the supporting member and the protective film. The first elastic member may fill at least a part of a space formed by the sealing member, a third portion of the protective film extending from the first portion to the second portion, and the supporting member.

The first elastic member and the second elastic member according to the above-described embodiment may protect the display driving circuit. The first elastic member and the second elastic member support the display panel, thereby preventing the display panel from being sagging. As the first elastic member and the second elastic member prevent the display panel from sagging, damage due to contact of the display panel with the supporting member may be reduced. The above-described embodiment may have various effects including the above-described effects.

According to an embodiment, the electronic device may further include a resin (e.g., the resin 620 of FIG. 6). The resin may be in contact with a second side surface opposite to a first side surface of the display driving circuit facing the first elastic member. The resin may be interposed between the display panel and the protective film.

According to an embodiment, the thickness of the resin may be thicker than the thickness of the display driving circuit.

According to an embodiment, the protective film may form an air gap between the display driving circuit and the second portion. The resin according to the above-described embodiment may protect the display driving circuit. The resin may prevent the display panel from sagging by supporting the display panel. The resin may be attached to the side surface of the display driving circuit to prevent damage to the side surface of the display driving circuit, and provide an air gap between the display driving circuit and the protective film or between the display driving circuit and the supporting member. Based on the providing of an air gap between the display driving circuit and the supporting member, damage caused by the contact of the display driving circuit with the supporting member may be reduced. The above-described embodiment may have various effects including the above-described effects.

According to an embodiment, a distance between the display driving circuit and the first elastic member may be shorter than a distance between the first elastic member and the sealing member. According to an embodiment, sagging of the display panel may be reduced within an area in which the display driving circuit is disposed, by the first elastic member disposed adjacent to the display driving circuit. A contact or collision between the display driving circuit and the supporting member may be reduced, by reduction of sagging of the display panel within the area where the display driving circuit is disposed. The above-described embodiment may have various effects including the above-described effects.

According to an embodiment, the sealing member may include a tape interposed between the sidewall of the housing and the first elastic member and extending in a closed curve form on the support portion.

The closed curve of the sealing member may surround at least a part of the side surface of the display driving circuit. According to an embodiment, the sealing member may prevent moisture or foreign materials from flowing into the display driving circuit by surrounding the display driving circuit. The above-described embodiment may have various effects including the above-described effects.

According to an embodiment, the electronic device may further include the second elastic member spaced apart from the display driving circuit and in contact with the support portion. The display driving circuit may be disposed between the first elastic member and the second elastic member. According to an embodiment, the protective film may extend from the first elastic member, surround the display driving circuit, and extend between the second elastic member and the flexible display panel. According to the above-described embodiment, the display driving circuit may be elastically supported by disposing the first elastic members and the second elastic members on both sides of the display driving circuit. The display driving circuit may reduce external impact. The above-described embodiment may have various effects including the above-described effects.

The flexible display panel may further include a flexible printed circuit board (e.g., the flexible printed circuit board 430 of FIG. 6) electrically connected to the display driving circuit and in contact with the protective film. The flexible printed circuit board may be supported by the protective film. The protective film may be supported by the second elastic member.

The support portion may include a first opening (e.g., the first opening 805 of FIG. 8B). The first opening may surround the display driving circuit when the flexible display panel is viewed from above. According to the above-described embodiment, the first opening may provide an air gap on the rear surface of the display driving circuit to mitigate impact transmitted to the display driving circuit. The above-described embodiment may have various effects including the above-described effects.

According to an embodiment, the electronic device may further include a battery (e.g., the battery 255 of FIG. 6) disposed in the housing and an adhesive member (e.g., the adhesive member 651 of FIG. 6) coupling the battery and the support portion. According to the above-described embodiment, the battery may be coupled to the support portion and stably disposed. The above-described embodiment may have various effects including the above-described effects.

According to an embodiment, the support portion may be disposed between the flexible display panel and the battery. According to an embodiment, the adhesive member may include a second opening overlapping the first opening when the display is viewed from above. According to the above-described embodiment, the adhesive member may expand the air gap by including the second opening. The above-described embodiment may have various effects including the above-described effects.

According to an embodiment, the electronic device may further include a battery (e.g., the battery 255 of FIG. 8A)) disposed within the electronic device and an adhesive member (e.g., the adhesive members 851 and 852 of FIG. 8A) to attach the battery and the support portion. According to an embodiment, the support portion may be disposed between the flexible display panel and the battery. The adhesive member (e.g., the adhesive member 860 of FIG. 8B) may include a non-adhesive area (e.g., the adhesive member 863 corresponding to the opening of FIG. 8B) overlapping the first opening when the display is viewed from above. According to an embodiment, the non-adhesive area may prevent damage to the battery by preventing direct contact between the battery and the supporting member. The adhesive member including the non-adhesive area may reduce the attachment of foreign materials to the exposed portion. The above-described embodiment may have various effects including the above-described effects.

According to an embodiment, the electronic device may further include the third elastic member (e.g., the buffer 890 in FIG. 8C) occupying at least a part of the first opening. The third elastic member may be in contact with the protective film. According to the above-described embodiment, the elastic member may fill the air gap and elastically support the display driving circuit. The elastic member may alleviate the external impact transmitted to the display driving circuit. The above-described embodiment may have various effects including the above-described effects.

According to an embodiment, the electronic device may further include a second elastic member (e.g., the second elastic member 520 of FIG. 8C) disposed on the supporting member and surrounding at least a part of an edge of the first opening.

According to an embodiment, the electronic device may further include a battery disposed inside the electronic device and an adhesive member attaching the battery and the support portion. The third elastic member may be coupled to the battery through the adhesive member. According to the above-described embodiment, the elastic member may be attached to the battery through the adhesive member and may be disposed at a designated position under the display driving circuit. Even with an external shock, the position of the elastic member can be maintained. The above-described embodiment may have various effects including the above-described effects.

According to an embodiment, the support portion may include a step portion disposed between the first elastic member and the display driving circuit.

According to an embodiment, an electronic device (e.g., the electronic device 101 of FIG. 2C) may comprising a first housing (e.g., the first housing 210 in FIG. 2C) having a first surface facing a first direction, a second housing (e.g., the second housing 220 of FIG. 2C) including a sidewall (e.g., the second side surface 223 in FIG. 2C) providing at least a portion of a side surface of the electronic device and a supporting member (e.g., the second supporting member 280 of FIG. 2C) extending into the electronic device from the sidewall and having a second surface facing the first direction, and a hinge structure (e.g., the hinge construction 260 in FIG. 2C) providing an unfolded state in which the first surface and the second surface face the same direction or a folded state in which the first surface and the second surface face each other, by rotatably connecting the first housing 210 and the second housing 220 with respect to a folding axis. The electronic device may include a flexible display (e.g., the display driving circuit 410 of FIG. 6) disposed on the first surface and the second surface across the folding axis and including a first display area corresponding to the first surface, a second display area corresponding to the second surface, and a third display area between the first display area and the second display area. The display may include a flexible display panel (e.g., the display panel 610 in FIG. 6), a protective film (e.g., the protective film 420 in FIG. 6) extending along the first surface of the flexible display panel from the edge of the flexible display toward the inside of the electronic device, and a display driving circuit (e.g., the display driving circuit 410 of FIG. 6) disposed between the protective film and the flexible display panel. The electronic device may include a sealing member (e.g., the sealing member 580 of FIG. 6) extending along the sidewall and disposed between the support portion and the protective film. The electronic device may include a first elastic member (e.g., the first elastic member 580 in FIG. 6) disposed between the support portion and the protective film and elastically supporting the protective film. The electronic device may include a resin (e.g., the resin 620 in FIG. 6) in contact with the second side surface facing the first side surface of the display driving circuit facing the first elastic member. The protective film may include a first portion (e.g., the first portion 420a of FIG. 6) in contact with the sealing member, a second portion (e.g., the second portion 420b of FIG. 6) contacting the supporting member and different from the first portion, and a third portion (e.g., the third portion 420c of FIG. 6) extending from the first portion to the second portion. The sealing member, the third portion, and the supporting member may surround the first elastic member.

According to an embodiment, the first elastic member and the second elastic member may protect the display driving circuit. The first elastic member and the second elastic member may prevent the display panel from sagging by supporting the display panel. The first elastic member and the second elastic member may reduce damage caused by the display panel contacting the supporting member by preventing the display panel from sagging. The above-described embodiment may have various effects including the above-described effects. According to an aspect of the disclosure, an electronic device may comprise: a first housing; a second housing; a hinge structure rotatably connecting the first housing and the second housing; a display including a display panel disposed on the first housing and the second housing across the hinge structure, a display driving circuit disposed on a surface of the display panel, and a protective film surrounding the display driving circuit; a supporting member supporting the display and disposed on a part of the first housing or the second housing; a sealing member blocking at least a portion of a path of foreign matter introduced from an outside and disposed between the protective film and the supporting member; and a first elastic member disposed between the protective film and the supporting member; wherein the protective film includes a first portion in contact with the sealing member and a second portion in contact with a part of the display driving circuit, wherein the first elastic member is disposed between the supporting member and the protective film, and is covered by a third portion of the protective film extending from the first portion to the second portion and the supporting member.

According to an aspect of the disclosure, the electronic device may further comprise a resin in contact with a second side surface opposite to a first side surface of the display driving circuit facing the first elastic member; wherein the resin contacts the display panel and the protective film and is configured to support the display panel.

According to an aspect of the disclosure, the resin may be thicker than the display driving circuit.

According to an aspect of the disclosure, the display driving circuit may be spaced apart from the second portion of the protective film in the direction in which the display panel faces.

According to an aspect of the disclosure, a distance between the display driving circuit and the first elastic member may be shorter than a distance between the first elastic member and the sealing member.

According to an aspect of the disclosure, the sealing member may be disposed between a sidewall of the first housing or the second housing and the first elastic member and includes a tape of a closed curve extending on the supporting member.

According to an aspect of the disclosure, the display driving circuit may be disposed within the closed curve of the sealing member.

According to an aspect of the disclosure, the electronic device may further comprise a second elastic member spaced apart from the display driving circuit and in contact with the supporting member, wherein the display driving circuit is disposed between the first elastic member and the second elastic member, and wherein the protective film extends from the first elastic member and surrounds the display driving circuit, a part of the protective film disposed between the second elastic member and the display panel.

According to an aspect of the disclosure, the display panel may further comprise a flexible printed circuit board electrically connected to the display driving circuit and in contact with the protective film, and wherein the flexible printed circuit board and the protective film is supported by the elastic member.

According to an aspect of the disclosure, the supporting member may include a first opening overlapping the display driving circuit when the display panel is viewed from above.

According to an aspect of the disclosure, the electronic device may further comprise: a battery disposed in the electronic device; and an adhesive member attaching the battery and the supporting member; wherein the supporting member is disposed between the display panel and the battery, and wherein the adhesive member includes a second opening overlapping the first opening when the display is viewed from above.

According to an aspect of the disclosure, the electronic device may further comprise: a battery disposed in the electronic device; and an adhesive member attaching the battery and the supporting member; wherein the supporting member is disposed between the display panel and the battery, and wherein the adhesive member includes a non-adhesive area overlapping the first opening when the display is viewed from above.

According to an aspect of the disclosure, the electronic device may further comprise a buffer occupying at least a portion of the first opening, wherein the buffer is in contact with the protective film.

According to an aspect of the disclosure, the electronic device may further the second elastic member disposed on the supporting member and surrounding at least a portion of an edge of the first opening.

According to an aspect of the disclosure, the electronic device may further comprise: a battery disposed in the electronic device; and an adhesive member attaching the battery and the supporting member; wherein the buffer is disposed on the adhesive member.

According to an aspect of the disclosure, the supporting member may include a step portion disposed between the first elastic member and the display driving circuit.

According to another aspect of the disclosure, an electronic device may comprise: a first housing having a first surface facing a first direction; a second housing including a sidewall providing at least a portion of a side surface of the electronic device and a supporting member extending into the electronic device from the sidewall and having a second surface facing the first direction; a hinge structure providing an unfolded state in which the first surface and the second surface face the same direction or a folded state in which the first surface and the second surface face each other, by rotatably connecting the first housing and the second housing with respect to a folding axis; and a display disposed on the first surface and the second surface across the folding axis and including a first display area corresponding to the first surface, a second display area corresponding to the second surface, and a third display area between the first display area and the second display area, wherein the display including: a display panel; a protective film extending along a first surface of the display panel from the edge of the display toward the inside of the electronic device; and a display driving circuit disposed between the protective film and the display panel; a sealing member extending along the sidewall and disposed between the protective film and the supporting member; and a first elastic member disposed between the supporting member and the protective film and elastically supporting the protective film; and a resin contacting a second side surface facing a first side surface of the display driving circuit facing the first elastic member; wherein the protective film includes a first portion in contact with the sealing member, a second portion in contact with the supporting member, and the first portion, and a third portion extending from to the second portion, and wherein the first elastic member is covered by the third portion and the supporting member.

According to an aspect of the disclosure, the resin may be thicker than the display driving circuit, contacts the display panel and the protective film, and is configured to support the display panel.

According to an aspect of the disclosure, the display driving circuit may be spaced apart from the protective film in the direction in which the display panel faces and wherein the protective film is contact with the supporting member.

According to an aspect of the disclosure, a distance between the display driving circuit and the first elastic member may be shorter than a distance between the first elastic member and the sealing member.

According to an aspect of the disclosure, the sealing member may have a closed curve extending on the supporting member and is disposed between the sidewall of the second housing and the first elastic member.

According to an aspect of the disclosure, the display driving circuit may be disposed within the closed curve of the sealing member.

According to an aspect of the disclosure, the electronic device may further comprise a second elastic member spaced apart from the display driving circuit and in contact with the supporting member, wherein the display driving circuit is disposed between the first elastic member and the second elastic member, and wherein the protective film extends from the first elastic member between the second elastic member and the display panel and surrounds the display driving circuit and the resin.

According to an aspect of the disclosure, the display panel may further comprise a flexible printed circuit board electrically connected to the display driving circuit and in contact with the protective film, and wherein the flexible printed circuit board and the protective film is supported by the elastic member.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 200) comprising:
a first housing (210);
a second housing (220);
a hinge structure (260) configured to rotatably connect the first housing (210) and the second housing (220);
a display (230) including a display panel (400; 610) disposed on the first housing (210) and the second housing (220) across the hinge structure (260), and a display driving circuit (410) disposed on a rear surface of the display panel (400; 610);
a supporting member (601) supporting the display (230) and disposed on a part of the first housing (210) or the second housing (220);
a sealing member (580) configured to block at least a portion of a path of foreign matter introduced from an outside and disposed between the display (230) and the supporting member (601); and
a first elastic member (510) disposed between the display driving circuit (410) and the sealing member (580).

2. The electronic device according to claim 1, further comprising a resin (620) in contact with a second side surface opposite to a first side surface of the display driving circuit (410) facing the first elastic member (510);
wherein the resin (620) contacts the display panel (400; 610) and the protective film (420) and is configured to support the display panel (400; 610).

3. The electronic device according to claim 2, wherein the resin (620) is thicker than the display driving circuit (410).

4. The electronic device according to any one of the preceding claims, wherein the display driving circuit (410) is spaced apart from a second portion (420b) of the protective film (420) in the direction in which the display panel (400; 610) faces.

5. The electronic device according to any one of the preceding claims, wherein a distance between the display driving circuit (410) and the first elastic member (510) is shorter than a distance between the first elastic member (510) and the sealing member (580).

6. The electronic device according to any one of the preceding claims, wherein the sealing member (580) is disposed between a sidewall of the first housing (210) or the second housing (220) and the first elastic member (510) and includes a tape of a closed curve extending on the supporting member (601).

7. The electronic device according to claim 6, wherein the display driving circuit (410) is disposed within the closed curve of the sealing member (580).

8. The electronic device according to any one of the preceding claims, further comprising a second elastic member (520) spaced apart from the display driving circuit (410) and in contact with the supporting member (601),
wherein the display driving circuit (410) is disposed between the first elastic member (510) and the second elastic member (520), and
wherein the protective film (420) extends from the first elastic member (510) and surrounds the display driving circuit (410), a part of the protective film (420) disposed between the second elastic member (520) and the display panel (400; 610).

9. The electronic device according to any one of the preceding claims, wherein the display panel (400; 610) further comprises a flexible printed circuit board (430) electrically connected to the display driving circuit (410) and in contact with the protective film (420), and
wherein the flexible printed circuit board (430) and the protective film (420) is supported by the elastic member (520).

10. The electronic device according to any one of the preceding claims, wherein the supporting member (601) includes a first opening overlapping the display driving circuit (410) when the display panel (400; 610) is viewed from above.

11. The electronic device according to claim 10, further comprising:
a battery (255) disposed in the electronic device (101; 200); and
an adhesive member (651) attaching the battery (255) and the supporting member (601);
wherein the supporting member (601) is disposed between the display panel (400; 610) and the battery (255), and
wherein the adhesive member (651) includes a second opening overlapping the first opening when the display (230) is viewed from above.

12. The electronic device according to claim 10 or claim 11, further comprising:
a battery (255) disposed in the electronic device (101; 200); and
an adhesive member (651) attaching the battery (255) and the supporting member (601);
wherein the supporting member (601) is disposed between the display panel (400; 610) and the battery (255), and
wherein the adhesive member (651) includes a non-adhesive area overlapping the first opening when the display (230) is viewed from above.

13. The electronic device according to claim 10 to 12, further comprising at least one of:
a buffer (890) occupying at least a portion of the first opening, wherein the buffer (890) is in contact with the protective film (420); and
a second elastic member (520) disposed on the supporting member (601) and surrounding at least a portion of an edge of the first opening.

14. The electronic device according to claim 13,
wherein the buffer (890) is disposed on the adhesive member (651).

15. The electronic device according to any one of the preceding claims, wherein the supporting member (601) includes a step portion disposed between the first elastic member (510) and the display driving circuit (410).

## Patentansprüche

1. Elektronische Vorrichtung (101; 200), umfassend:
ein erstes Gehäuse (210);
ein zweites Gehäuse (220);
eine Scharnierstruktur (260), die konfiguriert ist, um das erste Gehäuse (210) und das zweite Gehäuse (220) drehbar miteinander zu verbinden;
eine Anzeige (230), die eine Anzeigetafel (400; 610), die auf dem ersten Gehäuse (210) und dem zweiten Gehäuse (220) über der Scharnierstruktur (260) angeordnet ist, und eine Anzeigetreiberschaltung (410), die auf einer Rückfläche der Anzeigetafel (400; 610) angeordnet ist, umfasst;
ein Stützelement (601), das die Anzeige (230) stützt und auf einem Teil des ersten Gehäuses (210) oder des zweiten Gehäuses (220) angeordnet ist;
ein Abdichtungselement (580), das so konfiguriert ist, dass es mindestens einen Abschnitt eines Weges von Fremdkörpern blockiert, die von außen eingeführt werden, und zwischen der Anzeige (230) und dem Stützelement (601) angeordnet ist; und
ein erstes elastisches Element (510), das zwischen der Anzeigetreiberschaltung (410) und dem Abdichtungselement (580) angeordnet ist.

2. Elektronische Vorrichtung nach Anspruch 1, ferner umfassend ein Harz (620), das mit einer zweiten Seitenfläche in Kontakt steht, die einer ersten Seitenfläche der Anzeigetreiberschaltung (410) gegenüberliegt, die dem ersten elastischen Element (510) zugewandt ist;
wobei das Harz (620) mit der Anzeigetafel (400; 610) und dem Schutzfilm (420) in Kontakt steht und konfiguriert ist, um die Anzeigetafel (400; 610) zu stützen.

3. Elektronische Vorrichtung nach Anspruch 2, wobei das Harz (620) dicker ist als die Anzeigetreiberschaltung (410).

4. Elektronische Vorrichtung nach einem der vorhergehenden Ansprüche, wobei die Anzeigetreiberschaltung (410) von einem zweiten Abschnitt (420b) des Schutzfilms (420) in der Richtung beabstandet ist, in die die Anzeigetafel (400; 610) weist.

5. Elektronische Vorrichtung nach einem der vorhergehenden Ansprüche, wobei ein Abstand zwischen der Anzeigetreiberschaltung (410) und dem ersten elastischen Element (510) kürzer ist als ein Abstand zwischen dem ersten elastischen Element (510) und dem Abdichtungselement (580).

6. Elektronische Vorrichtung nach einem der vorhergehenden Ansprüche, wobei das Abdichtungselement (580) zwischen einer Seitenwand des ersten Gehäuses (210) oder des zweiten Gehäuses (220) und dem ersten elastischen Element (510) angeordnet ist und ein Band mit einer geschlossenen Kurve enthält, das sich auf dem Stützelement (601) erstreckt.

7. Elektronische Vorrichtung nach Anspruch 6, wobei die Anzeigetreiberschaltung (410) innerhalb der geschlossenen Kurve des Abdichtungselements (580) angeordnet ist.

8. Elektronische Vorrichtung nach einem der vorhergehenden Ansprüche, ferner umfassend ein zweites elastisches Element (520), das von der Anzeigetreiberschaltung (410) beabstandet ist und in Kontakt mit dem Stützelement (601) steht,
wobei die Anzeigetreiberschaltung (410) zwischen dem ersten elastischen Element (510) und dem zweiten elastischen Element (520) angeordnet ist, und
wobei sich der Schutzfilm (420) vom ersten elastischen Element (510) erstreckt und die Anzeigetreiberschaltung (410) umgibt, wobei ein Teil des Schutzfilms (420) zwischen dem zweiten elastischen Element (520) und der Anzeigetafel (400; 610) angeordnet ist.

9. Elektronische Vorrichtung nach einem der vorhergehenden Ansprüche, wobei die Anzeigetafel (400; 610) ferner eine flexible Leiterplatte (430) umfasst, die elektrisch mit der Anzeigetreiberschaltung (410) verbunden ist und in Kontakt mit dem Schutzfilm (420) steht, und
wobei die flexible Leiterplatte (430) und der Schutzfilm (420) vom elastischen Element (520) gestützt werden.

10. Elektronische Vorrichtung nach einem der vorhergehenden Ansprüche, wobei das Stützelement (601) eine erste Öffnung umfasst, die die Anzeigetreiberschaltung (410) überlappt, wenn die Anzeigetafel (400; 610) von oben betrachtet wird.

11. Elektronische Vorrichtung nach Anspruch 10, ferner umfassend:
eine Batterie (255), die in der elektronischen Vorrichtung (101; 200) angeordnet ist; und
ein Klebeelement (651), das die Batterie (255) und das Stützelement (601) befestigt;
wobei das Stützelement (601) zwischen der Anzeigetafel (400; 610) und der Batterie (255) angeordnet ist, und
wobei das Klebeelement (651) eine zweite Öffnung enthält, die sich mit der ersten Öffnung überlappt, wenn die Anzeige (230) von oben betrachtet wird.

12. Elektronische Vorrichtung nach Anspruch 10 oder Anspruch 11, ferner umfassend:
eine Batterie (255), die in der elektronischen Vorrichtung (101; 200) angeordnet ist; und
ein Klebeelement (651), das die Batterie (255) und das Stützelement (601) befestigt;
wobei das Stützelement (601) zwischen der Anzeigetafel (400; 610) und der Batterie (255) angeordnet ist, und
wobei das Klebeelement (651) einen nicht klebenden Bereich enthält, der die erste Öffnung überlappt, wenn die Anzeige (230) von oben betrachtet wird.

13. Elektronische Vorrichtung nach Anspruch 10 bis 12, ferner umfassend mindestens eines von Folgendem:
einen Puffer (890), der zumindest einen Abschnitt der ersten Öffnung einnimmt, wobei der Puffer (890) in Kontakt mit dem Schutzfilm (420) steht; und
ein zweites elastisches Element (520), das auf dem Stützelement (601) angeordnet ist und mindestens einen Abschnitt eines Randes der ersten Öffnung umgibt.

14. Elektronische Vorrichtung nach Anspruch 13,
wobei der Puffer (890) auf dem Klebeelement (651) angeordnet ist.

15. Elektronische Vorrichtung nach einem der vorhergehenden Ansprüche, wobei das Stützelement (601) einen Stufenabschnitt umfasst, der zwischen dem ersten elastischen Element (510) und der Anzeigetreiberschaltung (410) angeordnet ist.

## Revendications

1. Dispositif électronique (101 ; 200), comprenant :
un premier boîtier (210) ;
un deuxième boîtier (220) ;
une structure de charnière (260) configurée pour relier de manière rotative le premier boîtier (210) et le deuxième boîtier (220) ;
un affichage (230) comprenant un panneau d'affichage (400 ; 610) disposé sur le premier boîtier (210) et le deuxième boîtier (220) à travers la structure de charnière (260), et un circuit de commande d'affichage (410) disposé sur une surface arrière du panneau d'affichage (400 ; 610) ;
un élément de support (601) supportant l'affichage (230) et disposé sur une partie du premier boîtier (210) ou du deuxième boîtier (220) ;
un élément d'étanchéité (580) configuré pour bloquer au moins une partie d'un chemin de matières étrangères introduites depuis un extérieur, et disposé entre l'affichage (230) et l'élément de support (601) ; et
un premier élément élastique (510) disposé entre le circuit de commande d'affichage (410) et l'élément d'étanchéité (580).

2. Dispositif électronique selon la revendication 1, comprenant en outre une résine (620) en contact avec une deuxième surface latérale opposée à une première surface latérale du circuit de commande d'affichage (410) faisant face au premier élément élastique (510) ;
dans lequel la résine (620) entre en contact avec le panneau d'affichage (400 ; 610) et le film de protection (420) et est configurée pour supporter le panneau d'affichage (400 ; 610).

3. Dispositif électronique selon la revendication 2, dans lequel la résine (620) est plus épaisse que le circuit de commande d'affichage (410).

4. Dispositif électronique selon l'une quelconque des revendications précédentes, dans lequel le circuit de commande d'affichage (410) est espacé d'une deuxième partie (420b) du film de protection (420) dans la direction dans laquelle le panneau d'affichage (400 ; 610) est orienté.

5. Dispositif électronique selon l'une quelconque des revendications précédentes, dans lequel une distance entre le circuit de commande d'affichage (410) et le premier élément élastique (510) est plus courte qu'une distance entre le premier élément élastique (510) et l'élément d'étanchéité (580).

6. Dispositif électronique selon l'une quelconque des revendications précédentes, dans lequel l'élément d'étanchéité (580) est disposé entre une paroi latérale du premier boîtier (210) ou du deuxième boîtier (220) et le premier élément élastique (510) et comprend un ruban d'une courbe fermée s'étendant sur l'élément de support (601).

7. Dispositif électronique selon la revendication 6, dans lequel le circuit de commande d'affichage (410) est disposé à l'intérieur de la courbe fermée de l'élément d'étanchéité (580).

8. Dispositif électronique selon l'une quelconque des revendications précédentes, comprenant en outre un deuxième élément élastique (520) espacé du circuit de commande d'affichage (410) et en contact avec l'élément de support (601),
dans lequel le circuit de commande d'affichage (410) est disposé entre le premier élément élastique (510) et le deuxième élément élastique (520), et
dans lequel le film de protection (420) s'étend à partir du premier élément élastique (510) et entoure le circuit de commande d'affichage (410), une partie du film de protection (420) étant disposée entre le deuxième élément élastique (520) et le panneau d'affichage (400 ; 610).

9. Dispositif électronique selon l'une quelconque des revendications précédentes, dans lequel le panneau d'affichage (400 ; 610) comprend en outre une carte de circuit imprimé flexible (430) connectée électriquement au circuit de commande d'affichage (410) et en contact avec le film de protection (420), et
dans lequel la carte de circuit imprimé flexible (430) et le film de protection (420) sont supportés par l'élément élastique (520).

10. Dispositif électronique selon l'une quelconque des revendications précédentes, dans lequel l'élément de support (601) comprend une première ouverture chevauchant le circuit de commande d'affichage (410) lorsque le panneau d'affichage (400 ; 610) est vu du dessus.

11. Dispositif électronique selon la revendication 10, comprenant en outre :
une batterie (255) disposée dans le dispositif électronique (101 ; 200) ; et
un élément adhésif (651) fixant la batterie (255) et l'élément de support (601) ;
dans lequel l'élément de support (601) est disposé entre le panneau d'affichage (400 ; 610) et la batterie (255), et
dans lequel l'élément adhésif (651) comprend une deuxième ouverture chevauchant la première ouverture lorsque l'affichage (230) est vu du dessus.

12. Dispositif électronique selon la revendication 10 ou la revendication11, comprenant en outre :
une batterie (255) disposée dans le dispositif électronique (101 ; 200) ; et
un élément adhésif (651) fixant la batterie (255) et l'élément de support (601) ;
dans lequel l'élément de support (601) est disposé entre le panneau d'affichage (400 ; 610) et la batterie (255), et
dans lequel l'élément adhésif (651) comprend une zone non adhésive chevauchant la première ouverture lorsque l'affichage (230) est vu du dessus.

13. Dispositif électronique selon les revendications 10 à 12, comprenant en outre au moins l'un de ce qui suit :
un tampon (890) occupant au moins une partie de la première ouverture, dans lequel le tampon (890) est en contact avec le film de protection (420) ; et
un deuxième élément élastique (520) disposé sur l'élément de support (601) et entourant au moins une partie d'un bord de la première ouverture.

14. Dispositif électronique selon la revendication 13,
dans lequel le tampon (890) est disposé sur l'élément adhésif (651).

15. Dispositif électronique selon l'une quelconque des revendications précédentes, dans lequel l'élément de support (601) comprend une partie étagée disposée entre le premier élément élastique (510) et le circuit de commande d'affichage (410).
